Europäisches Patentamt

European Patent Office

Office européen des brevets

(19)

(11) **EP 0 660 116 B1**

(12) **FASCICULE DE BREVET EUROPEEN**

(45) Date de publication et mention
de la délivrance du brevet:
**25.03.1998 Bulletin 1998/13**

(51) Int Cl.⁶: **G01P 1/04**, G01P 3/489,
H03K 5/00

(21) Numéro de dépôt: **94119276.7**

(22) Date de dépôt: **07.12.1994**

(54) **Dispositif de mesure de la vitesse de rotation d'un moteur thermique, notamment pour véhicule automobile**

Vorrichtung zur Messung der Drehgeschwindigkeit eines Verbrennungsmotors, insbesondere für Kraftfahrzeuge

Device for measuring the rotational speed of an internal combustion engine, especially for motor vehicle

(84) Etats contractants désignés:
**DE ES GB IT NL SE**

(30) Priorité: **23.12.1993 FR 9315577**

(43) Date de publication de la demande:
**28.06.1995 Bulletin 1995/26**

(73) Titulaire: **VALEO EQUIPEMENTS ELECTRIQUES MOTEUR**
**94000 Créteil (FR)**

(72) Inventeurs:
• **Pierret, Jean-Marie**
**F-75012 Paris (FR)**
• **Richoux Christelle**
**F-94310 Orly (FR)**

(74) Mandataire: **Gamonal, Didier**
**Valeo Management Services**
**Propriété Industrielle**
**2, rue André Boulle,**
**B.P. 150**
**94004 Créteil (FR)**

(56) Documents cités:
EP-A- 0 261 451          EP-A- 0 296 295
DE-A- 3 114 062          DE-B- 1 276 719
FR-A- 2 583 166          US-A- 4 742 297
US-A- 5 103 413

**Description**

La présente invention concerne de façon générale un dispositif de mesure de la vitesse de rotation d'un moteur thermique, notamment pour véhicule automobile.

Dans l'art antérieur, un dispositif de mesure de la vitesse de rotation d'un moteur thermique comporte une machine électrique tournante, couplée mécaniquement audit moteur délivrant au moins un signal ayant un nombre d'impulsions déterminé par tour qui est, d'une manière générale, fonction d'une des grandeurs caractéristiques de ladite machine tournante, et un appareil de mesure conçu pour exploiter ledit signal. Autrement dit, ledit appareil de mesure est dédié à ladite machine tournante, ce qui est une contrainte car si la caractéristique de la machine tournante vient à changer, une modification dans la conception de l'appareil de mesure s'avèrera nécessaire.

On retrouve ce problème en particulier dans un dispositif de mesure de la vitesse du moteur thermique dans un véhicule automobile, notamment dans un véhicule à moteur diesel, comprenant un alternateur, machine tournante entraînée par ce moteur, possédant un nombre de paire de pôles déterminé qui est une des caractéristiques de l'alternateur, ayant une vitesse proportionnelle à celle du moteur, délivrant trois signaux phase périodiques dont le nombre d'impulsions par tour est proportionnel au nombre de paire de pôle de l'alternateur, et un compte-tours, appareil de mesure conçu pour exploiter un desdits signaux phase.

De manière usuelle, les véhicules sont équipés d'un alternateur à six paires de pôle et le compte-tours est conçu pour réagir à un signal phase ayant un nombre d'impulsions par tour proportionnel à six.

Pour faire face à une demande croissante de puissance électrique des véhicules automobiles, notamment des poids lourds, due à l'augmentation de charges électriques fortes consommatrices de courant (l'éclairage, la climatisation, le dégivrage . . . ), il se révèle nécessaire d'augmenter la puissance délivrée par l'alternateur. Le volume disponible dans le compartiment moteur étant particulièrement réduit, l'une des solutions consiste à remplacer un alternateur à six paires de pôles par un alternateur à huit paires de pôles ayant le même encombrement.

Dans cette configuration le signal phase présente un nombre d'impulsions par tour proportionnel à huit et le compte-tours n'est plus adapté pour réagir à un tel signal phase.

Pour remédier à cet inconvénient, une des solutions peut consister à modifier le compte-tours, notamment sa graduation, pour l'adapter à un signal phase d'un alternateur à huit paires de pôles. Cette solution impose donc une contrainte supplémentaire car il faut deux compte-tours différents, un pour chaque type d'alternateur. Cette distinction rend impossible l'interchangeabilité des alternateurs à six paires de pôles et des alternateurs à huit paires de pôles dans les véhicules tout en conservant le même compte-tours.

Pour résoudre ce problème, la présente invention a pour objet de présenter un dispositif simple permettant de mesurer la vitesse d'un moteur thermique couplé mécaniquement à une machine électrique tournante pouvant délivrer un ou plusieurs signaux dont le nombre d'impulsions par tour peut être différent de celui pour lequel l'appareil de mesure a été conçu.

L'invention concerne à cet effet un dispositif de mesure de la vitesse de rotation d'un moteur thermique, notamment pour véhicule automobile, comprenant:

- un appareil de mesure apte à recevoir un signal de manière à indiquer une valeur correspondant à la vitesse de rotation dudit moteur,

- une machine électrique tournante, couplée mécaniquement au moteur thermique et apte à délivrer au moins un signal représentatif de la vitesse de rotation dudit moteur thermique, ledit signal présentant une caractéristique dépendante de la nature de machine électrique tournante, un moyen de conversion disposé entre ladite machine tournante et ledit appareil de mesure, apte à délivrer audit appareil de mesure un signal ayant un premier nombre d'impulsions par tour, à partir d'un ou plusieurs signaux ayant un deuxième nombre d'impulsions par tour délivré par ladite machine tournante, le deuxième nombre étant différent du premier nombre, ledit appareil de mesure consistant en un compte-tours destiné à recevoir dudit moyen de conversion un signal ayant undit premier nombre d'impulsions par tour, et ladite machine tournante consistant en un alternateur délivrant des signaux phase (A11, A12, A13; A2; A3) ayant undit deuxième nombre d'impulsions par tour, suivant les enseignements du document US-A-4 742 297 caractérisé en ce que ledit premier nombre d'impulsions par tour est proportionnel à six et ledit deuxième nombre d'impulsions par tour est proportionnel à huit.

Selon une première forme de réalisation de l'invention ledit moyen de conversion est apte à délivrer audit compte-tours un signal ayant un premier nombre d'impulsions par tour, à partir de trois signaux phase ayant un deuxième nombre d'impulsions par tour délivrés par ledit alternateur.

Selon une seconde et troixième réalisations de l'invention, ledit moyen de conversion comporte des moyens aptes à délivrer audit compte-tours un signal ayant un premier nombre d'impulsions par tour, à partir d'un seul signal phase ayant un deuxième nombre d'impulsions par tour délivré par ledit alternateur.

Selon d'autres caractéristiques de la seconde forme de réalisation de l'invention:

- ledit signal phase étant un signal rectangulaire périodique PR et constitué d'alternances positives et négatives de durée TR, ledit moyen de conversion comporte des moyens aptes à déterminer un intervalle de deux périodes et à provoquer toutes les deux périodes une inversion dudit signal phase de manière à obtenir un signal présentant un premier nombre d'impulsions par tour et constitué d'alternances positives et négatives de durées égales à TR ou à deux fois TR

- ledit moyen de conversion comporte des moyens aptes à prolonger d'une durée déterminée une alternance positive de durée TR qui suit une alternance négative de durée TR.

- le moyen de conversion comporte des moyens aptes à prolonger d'une durée déterminée une alternance négative de durée TR qui suit une alternance positive de durée TR.

Selon d'autres caractéristiques de la troisième forme de réalisation de l'invention :

- le signal phase étant un signal rectangulaire périodique de période PR constitué notamment d'un front montant et d'un front descendant, ledit moyen de conversion comporte sur une durée égale à deux périodes PR commençant à un front montant, des premiers moyens aptes à retarder le premier front descendant d'un temps t31, des seconds moyens aptes à retarder le deuxième front montant d'un temps t32, des troisièmes moyens aptes à supprimer le deuxième front descendant et des quatrièmes moyens aptes à inverser le troisième front montant de manière à générer un signal comportant un premier nombre d'impulsions par tour.

- le temps t31 est égal à un tiers d'une demi-période PR du signal phase.

- le temps t32 est deux fois plus grand que t31.

D'une manière avantageuse, en particulier dans le domaine des véhicules automobiles, ledit moyen de conversion est intégré dans le boitier du régulateur de l'alternateur.

D'autres caractéristiques, buts et avantages de la présente invention apparaîtront mieux à la lecture de la description détaillée de modes de réalisation préférés de celle-ci, donnée à titre d'exemple et faite de référence aux dessins annexés, sur lesquels:

La figure 1 est un schéma de principe mettant en oeuvre le dispositif de mesure de l'invention dans un véhicule automobile.

La figure 2 est schéma électrique représentant un premier mode de réalisation préféré du module de conversion, partie dudit moyen de conversion, présent à la figure 1.

La figure 3 représente des chronogrammes illustrant le fonctionnement du premier mode de réalisation préféré du module de conversion.

La figure 4 est un schéma électrique représentant le deuxième mode de réalisation préféré du module de conversion.

La figure 5 représente des chronogrammes illustrant le fonctionnement du deuxième mode de réalisation préféré du module de conversion.

La figure 6 est un schéma électrique représentant un troisième mode de réalisation préféré du module de conversion.

La figure 7 représente des chronogrammes illustrant le fonctionnement du troisième mode de réalisation préféré du module de conversion.

Avant d'entamer la description des figures citées ci-dessus, quelques précisions des termes employés contribueront à la clarté du texte:

- Pour un signal rectangulaire périodique, une période comporte deux états:
  un premier état correspondant à une alternance se trouvant à un niveau logique "1", dite alternance positive
  un deuxième état correspondant à une alternance se trouvant à un niveau logique "0", dite alternance négative.

- Une impulsion est assimilable soit à une alternance positive d'une période, dans ce cas on dit que c'est une impulsion positive, soit à une alternance négative d'une période, dans ce cas on dit que c'est une impulsion négative. Par conséquent, par période, il n'y a qu'une impulsion positive ou négative.

Lorsqu'aucune indication particulière n'est mentionnée, le terme "impulsion" sans qualificatif signifie indifféremment une impulsion positive ou négative.

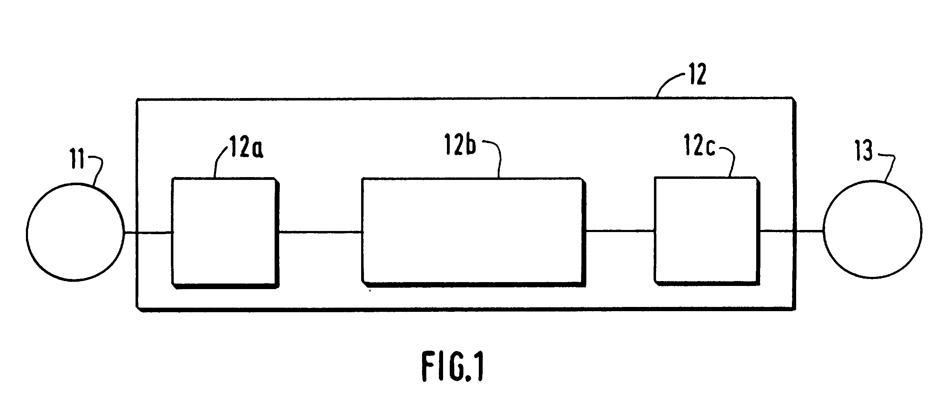

En référence tout d'abord à la figure 1, on a représenté un schéma de principe du dispositif comportant:

- une machine tournante constituée d'un alternateur 11 couplé mécaniquement au moteur thermique et apte à délivrer au moins un signal représentatif de la vitesse de rotation du moteur thermique, ledit signal présentant une caractéristique dépendante de la nature de la machine électrique tournante. De manière préférentielle, ledit signal représentatif est constitué par au moins l'un des signaux phase de l'alternateur, dont l'une des caractéristiques, son nombre d'impulsions par tour, dépend du nombre de paires de pôles de l'alternateur 11.

- un appareil de mesure constitué d'un compte-tours 13 apte à indiquer une valeur correspondant de la vitesse de rotation du moteur thermique.

Le dispositif comprend également un moyen de conversion 12 s'insérant entre l'alternateur 11 et le compte-tours 13 et apte à délivrer au compte-tours 13 un signal présentant un premier nombre d'impulsions par tour propotionnel à six à partir du signal ayant un deuxième nombre d'impulsions par tour délivré par l'alternateur 11.

Dans les exemples de réalisation qui vont suivre l'alternateur 11 est équipé de huit paires de pôles et son signal phase présente donc un deuxième nombre d'impulsions par tour n8 proportionnel à huit tandis que le compte-tours 13 est apte à recevoir un signal comportant un premier nombre d'impulsions par tour n6 proportionnel à six.

Le moyen de conversion 12 comprend:

- un module de mise en forme 12a permettant d'obtenir à partir d'un desdits signaux phase de l'alternateur 11 un signal rectangulaire périodique, ayant le même nombre d'impulsions par tour que le signal phase et des niveaux de tension compatibles avec les niveaux logiques des composants d'un module 12b décrit ultérieurement. Dans un mode de réalisation préféré, le signal phase varie de 0 à 14 Volts et le signal phase rectangulaire correspondant varie de 0 à 8 Volts. Mais d'autres niveaux de tension du signal phase et du signal rectangulaire sont envisageables. Le module de mise en forme 12a pouvant être réalisé par un quelconque montage électronique bien connu de l'Homme du métier, n'a pas été représenté en détails.

- un module de conversion 12b permettant de transformer ledit signal phase rectangulaire, désigné ci-après par signal d'entrée, en un signal ayant un premier nombre d'impulsions par tour proportionnel à six, désigné ci-après par signal de sortie. Des modes de réalisations préférés du module de conversion 12b seront détaillés ultérieurement.

- un module de puissance 12c permettant d'amplifier le signal de sortie et de donner en sortie un signal ayant des niveaux de tension suffisants pour être exploité par le compte-tours 13.

La figure 1 ne représente qu'un seul signal phase à l'entrée du moyen de conversion 12 et de son module de conversion 12b, ceci dit on peut éventuellement envisager d'utiliser plusieurs signaux phase délivrés par l'alternateur 11, à l'entrée du moyen de conversion 12.

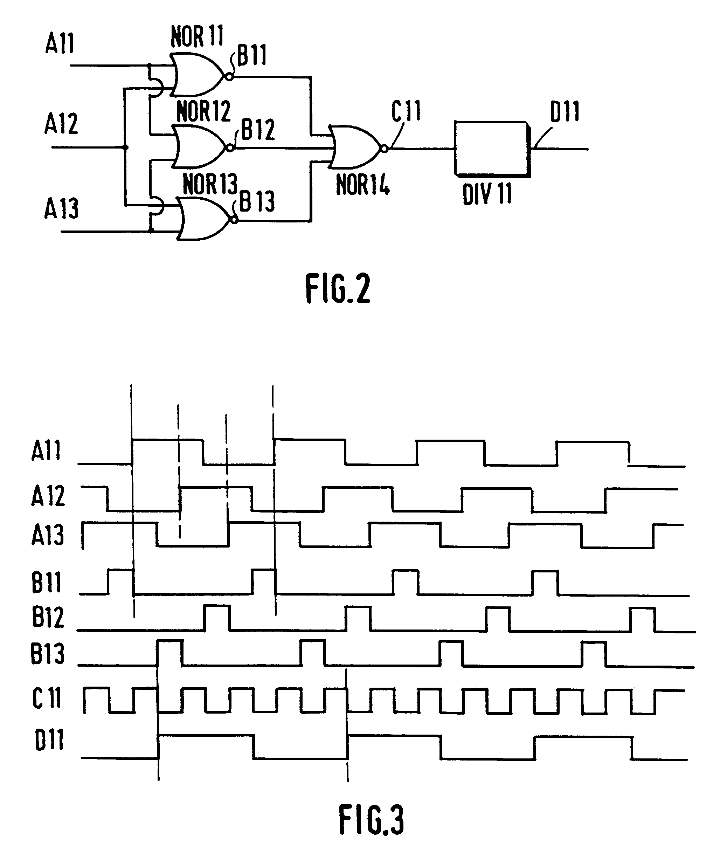

La figure 2 représentant un schéma électrique selon un premier mode de réalisation préféré du module de conversion 12b permettant de délivrer un signal ayant un premier nombre d'impulsions par tour proportionnel à six ou signal de sortie, à partir de trois signaux phase ayant un deuxième nombre d'impulsions par tour proportionnel à huit ou signaux d'entrée, désignés par A11, A12, A13 qui sont combinés, deux par deux, par des moyens logiques constitués par trois portes NON OU NOR11, NOR12, NOR13 générant respectivement en sortie les signaux B11, B12, B13 qui sont ensuite appliqués aux trois entrées d'une porte NON OU dénommée NOR14. La sortie de NOR14 est reliée à l'entrée d'un moyen diviseur par quatre DIV11 délivrant en sortie le signal D11.

On va maintenant expliquer en référence à la figure 3 le fonctionnement du schéma électrique décrit ci-dessus

On notera tout d'abord que le nombre d'impulsions par tour d'un signal phase délivré par un alternateur à N paires de pôle est proportionnel à N.

Notons n6 le nombre d'impulsions par tour d'un signal phase d'un alternateur à six paires de pôle et n8 le nombre d'impulsions par tour d'un signal phase d'un alternateur à huit paires de pôle. On constate que, en faisant le rapport de n6 sur n8, à une vitesse donnée de l'alternateur, on obtient un quotient de trois sur quatre, autrement dit :

$$n6 = 3 \times n8\,/4$$

Le premier mode de réalisation préféré dudit moyen de conversion consiste dans un premier temps de multiplier le nombre d'impulsions n8 des signaux d'entrée par trois puis de le diviser par quatre.

Les signaux A11, A12, A13 sont déphasés les uns par rapport aux autres d'un tiers de période. Les portes NOR11, NOR12, NOR13 permettent de générer respectivement dans les signaux B11, B12, B13 de même fréquence que A11, A12, A13, des alternances de niveaux logique "1" de longueur égale à un sixième de période. B11, B12, B13 combinés par NOR14 permettent d'obtenir un signal C11 dont la fréquence est trois fois plus grande que celle de B11, B12, B13, c'est à dire que C11 a un nombre d'impulsions par tour trois fois plus grand que A11, A12, A13. En effet, la porte NOR14 réalise une multiplication par trois de la fréquence des signaux B11, B12, B13. Le diviseur DIV11 réalise ensuite une division par quatre de la fréquence du signal C11 en donnant ainsi en sortie le signal D11 dont la durée d'une période est quatre fois plus grande que celle de C11 et donc présente un premier nombre d'impulsions n6 proportionnel à six.

Dans les deux modes de réalisation qui vont suivre, le moyen de conversion 12 comporte des moyens aptes à délivrer au compte-tour 13 un signal ayant un premier nombre d'impulsions par tour (n6) à partir d'un seul signal phase de l'alternateur 11.

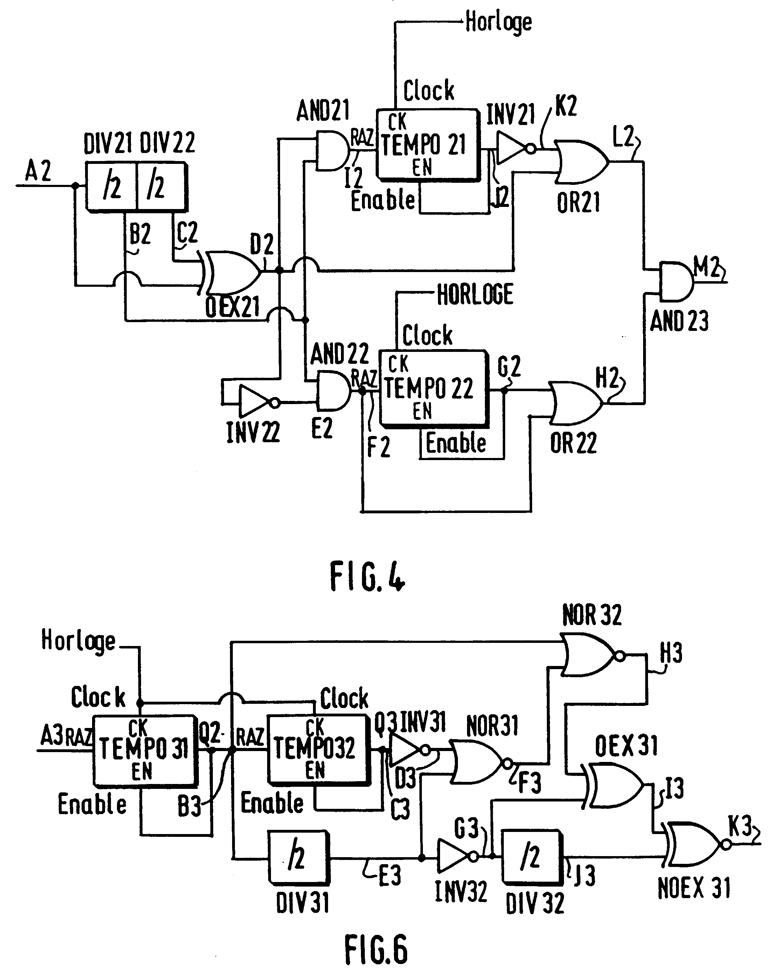

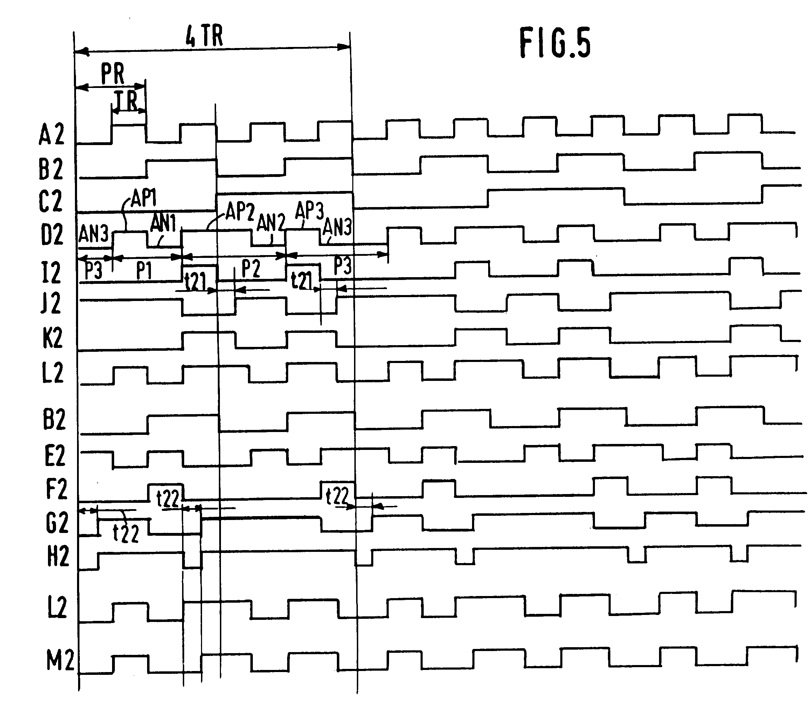

La figure 4 représente un schéma électrique selon un deuxième mode de réalisation préféré du module de conversion 12b utilisant un seul signal phase correspondant à un signal d'entrée désigné par A2 et appliqué à l'entrée d'un diviseur par quatre, réalisé par deux bascules DIV21 et DIV22. La sortie de DIV22 (signal C2) est réliée à une des deux entrées d'une porte OU EXCLUSIF OEX21 dont l'autre entrée reçoit le signal A2.

OEX21 délivre à sa sortie un signal D2 appliqué à une première entrée d'une porte ET désignée par AND21 dont la deuxième entrée est connectée à la sortie de DIV21 (signal B2). La sortie de AND21 (signal I2) est reliée à une entrée de "remise à zéro" RAZ d'un circuit de temporisation TEMPO21, implémenté en l'espèce sous forme d'un compteur numérique descendant cadencé par un signal d'horloge appliqué sur l'entrée "clock" CK de TEMPO21. La sortie de TEMPO21 délivrant un signal J2 est rebouclée sur son entrée "Enable" EN. Quand son entrée RAZ passe à un niveau logique "1", sa sortie se retrouve au niveau logique "0" et reste à ce niveau "0" tant que RAZ reste à "1". Le compteur commence à compter quand RAZ bascule à un niveau logique "0", et le compteur défile aussi longtemps que son entrée RAZ est à zéro, et sa sortie passe au niveau logique "1" lorsqu'un comptage prédéterminé est atteint, c'est à dire après l'écoulement d'une constante de temps t21 prédéterminée. Ledit compteur reste ensuite bloqué à "1" jusqu'au prochain passage à "1" de son entrée RAZ. Il est à noter que la constante de temps t21 est déterminée en fonction de la fréquence du signal d'horloge appliqué à l'entrée "Clock" de TEMPO21. La sortie du TEMPO21 ( signal J2) est reliée à l'entrée d'un inverseur INV21 dont la sortie (signal K2) est connectée à une des entrées d'une porte OU désignée par OR21, dont la deuxième entrée est reliée à la sortie de OEX21.

La sortie de OEX21 est aussi reliée à un inverseur INV22 dont la sortie (signal E2) est connectée à une entrée d'une porte ET représentée par AND22, l'autre entrée de AND22 est reliée à la sortie de DIV21. AND22 délivre en sortie un signal F2 appliqué à l'entrée RAZ d'un autre circuit de temporisation TEMPO22. Son entrée "Clock" CK reçoit un signal d'horloge et sa sortie est rebouclée sur son entrée "Enable" EN. Son fonctionnement est le même que TEMPO21 avec une constante de temps prédéterminée t22. Dans ce mode de réalisation préféré, t22 est égale à t21, par conséquent, TEMPO21 et TEMPO22 sont cadencés par le même signal d'horloge. La sortie de TEMPO22 (signal G2) est reliée à une première entrée d'une porte OU nommée OR22 dont l'autre entrée est connectée à la sortie de AND22.

La sortie de OR22 (signal H2) et la sortie de OR21 (signal L2) sont reliées aux deux entrées de la porte ET désignée par AND23 dont la sortie délivre un signal M2 qui est le signal de sortie du module de conversion et donc le signal appliqué au compte-tours 13 après amplification par le module de puissance 12c.

On va maintenant expliquer en référence à la figure 5 le fonctionnement du circuit tel qu'il a été décrit ci-dessus.

Le signal A2 a une période PR, chaque période PR comprenant une alternance positive et une alternance négative de durée TR. Pour une meilleure compréhension, l'explication suivante se limitera à un intervalle de temps 4TR comportant quatre périodes ou impulsions du signal A2.

Le signal B2 est le signal de sortie de DIV21 dont le signal d'entrée est A2. DIV21 multiplie par deux la période du signal A2, par conséquent, l'intervalle 4TR ne comporte plus que deux périodes.

Le signal C2 est le signal de sortie de DIV22 dont le signal d'entrée est B2. DIV22 multiplie par quatre la période du signal A2, par conséquent, l'intervalle 4TR ne comporte plus qu'une période.

La porte OEX21 combine le signal A2 et le signal C2 pour délivrer un signal D2 de la manière suivante : si C2 est au niveau logique "0", D2 est en phase avec A2, si C2 est au niveau logique "1", D2 est inversé par rapport à A2. On constate que le signal D2 correspond au signal A2 inversé toutes les deux périodes. Ainsi, pour obtenir le rapport de trois sur quatre précité, le deuxième mode de réalisation préféré consiste, dans un premier temps, à inverser toutes les deux périodes le signal d'entrée. Les chronogrammes A2 et D2 de la figure 5 montrent que quatre périodes, c'est à dire huit alternances de A2 correspondent à trois périodes P1, P2, P3, c'est à dire six alternances de D2 composées de trois alternances positives AP1, AP2, AP3 et trois alternances négatives AN1, AN2, AN3.

Cependant, sur un intervalle égal à 4TR, les trois périodes de D2 et donc les alternances correspondantes n'ont pas la même durée. De manière plus précise, la période P1 est restée égale à PR et les périodes P2 et P3 sont plus grandes que la période PR.

Autrement dit, pour le compte-tours 13 destiné à exploiter sur l'intervalle 4TR des périodes de longueur plus grande que PR, la période de longueur PR est sensiblement trop courte. En effet, suite à la réception d'une impulsion ou période trop courte, le compte-tours 13 n'est pas adapté à prendre en considération l'impulsion suivante, et voit ainsi à son entrée un nombre d'impulsion plus faible que celui attendu. Dans ce cas, l'aiguille du compte-tours 13 retombe vers zéro, on dit que le compte-tours "décroche".

Si le compte-tours 13 exploite le signal de sortie D2 sur impulsion positive (sur front montant), P1 est sensiblement trop courte et le compte-tours ne voit pas arriver l'impulsion suivante, par contre, si le compte-tours 13 exploite le signal de sortie D2 sur une impulsion négative (sur front descendant), AN2 et AP3 formant une période est sensiblement trop courte pour que le compte-tours 13 ait le temps de traiter l'impulsion négative suivante. Dans les deux cas on a le "décrochage" du compte-tours.

Pour y remédier, on prolonge, dans un deuxième temps, les alternances trop courtes d'une durée telle que la durée totale de l'alternance soit adaptée à commander correctement le compte-tours 13. On distinguera néanmoins deux cas:

- Le prolongement des alternances positives consistant à retarder sur front descendant
- Le prolongement des alternances négatives consistant à retarder sur front montant.

L'ensemble AND21, TEMPO21, et INV21 constitue des moyens permettant d'introduire un retard t21, constante de temps de TEMPO21, sur front descendant qui a pour but de prolonger l'alternance positive AP3 de durée TR qui suit l'alternance négative AN2 également de durée TR.

En effet, la porte AND21 combine D2 et B2 pour récupérer dans le signal I2 la moitié de AP2 et principalement l'alternance AP3. Le signal I2 est appliqué à l'entrée RAZ du TEMPO21 qui introduit un retard t21 au niveau des alternances négatives et sur front montant de J2. Dans l'intervalle 4TR, le retard t21 est présent deux fois. Pour retrouver ce retard dans les alternances positives comme souhaité, J2 est inversé par INV21 qui donne ainsi le signal K2. Seul le deuxième retard t21 de 4TR est intégré dans le signal L2 qui n'est autre que le résultat d'une combinaison par la porte OR21 du signal D2 obtenu après inversion de A2 par C2, et du signal K2, le premier retard est supprimé par le présence de AP2. Dans L2, on retrouve le signal D2 dont l'alternance AP3 est prolongée d'un temps t21.

L'ensemble des éléments INV22, AND22, TEMPO22 constitue des moyens permettant d'introduire un retard t22, constante de temps prédéterminée de TEMPO22, sur front montant qui a pour but de prolonger l'alternance négative AN1 de durée TR qui suit l'alternance positive AP1 également de durée TR.

La porte AND22 permet de récupérer dans F2 l'inverse de la moitié de AN3 et principalement l'inverse de AN1 en combinant B2et l'inverse de D2, E2. Le TEMPO22 dont son entrée RAZ est F2, introduit dans son signal de sortie G2 un retard t22 au niveau des deux alternances négatives de l'intervalle 4TR. D'autre part, en combinant G2 et F2 par la porte OR22, on obtient le signal H2 dont les alternances négatives sont de durée t22. On a ensuite pour but d'incorporer le premier retard t22 dans le signal L2 qui est en fait le signal D2 dont l'alternance AP3 a été prolongée de t21, en combinant H2 et L2 par la porte AND23 pour délivrer le signal résultat M2 ayant l'alternance AP3 prolongée de t21 et l'alternance AN1 prolongée de t22.

Ainsi, on a généré un signal M2 comportant trois périodes de longueur moyenne adaptée au compte-tours 13 permettant ainsi un fonctionnement correct de celui-ci.

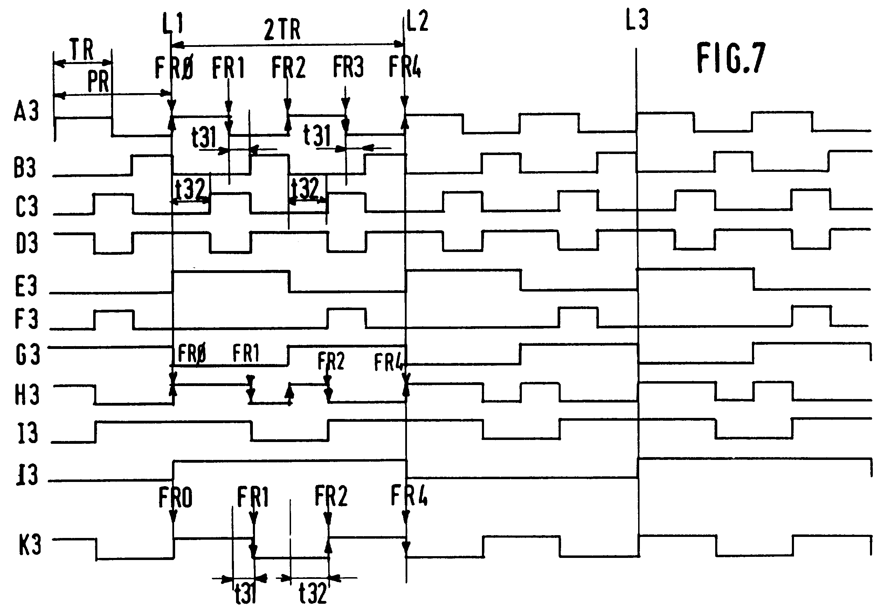

On se réfère maintenant aux figures 6 et 7 qui illustrent un troisième mode de réalisation préféré de l'invention dont le but est d'assurer une symétrie du signal de sortie à une vitesse nominale dudit moteur.

La figure 6 représente un schéma électrique mettant en oeuvre le module de conversion 12b utilisant en entrée un seul signal phase ayant un nombre d'impulsions proportionnel à huit.

Ledit signal d'entrée, désigné également par A3 sur la figure 6, est appliqué à une entrée de remise à zéro RAZ d'un circuit de temporisation TEMPO31, implémenté en l'espèce sous forme d'un compteur numérique descendant cadencé par un signal d'horloge appliqué sur l'entrée "Clock" CK de TEMPO31. La sortie Q2 de TEMPO31 est rebouclée sur son entrée "Enable" EN. Son fonctionnement est identique à celui de TEMPO21 et de TEMPO22 décrits ci-dessus, avec une constante de temps prédéterminée t31. La sortie Q2 de TEMPO31 (signal B3) est reliée, d'une part, à l'entrée d'un diviseur par deux, DIV31, qui délivre un signal E3, et, d'autre part, à l'entrée RAZ d'un autre temporisateur TEMPO32 de même type qui reçoit sur son entrée "Clock" CK le même signal d'horloge que le TEMPO31 et a pour constante de temps prédéterminée t32. La sortie Q3 de TEMPO32 (signal C3) est d'une part rebouclée sur son entrée EN et d'autre part reliée à l'entrée d'un inverseur désigné par INV31 dont la sortie (signal D3) est connectée à une des deux entrées d'une porte NON OU nommée NOR31. La deuxième entrée de NOR31 est reliée à la sortie de DIV31 (signal E3). La sortie de NOR31 (signal F3) est ensuite reliée à la première entrée de la porte NON OU, NOR32 dont la deuxième entrée est reliée à Q2, sortie de TEMPO31. La sortie de NOR32 (signal H3) est ensuite reliée à une porte OU EXCLUSIF désignée par OEX31 dont l'autre entrée reçoit le signal G3, signal de sortie d'un inverseur désigné par INV32 dont l'entrée est connectée à la sortie de DIV31. La sortie de la porte OEX31 (signal I3) est reliée à une des deux entrée d'une porte NON OU EXCLUSIF, NOEX31 qui reçoit sur l'autre entrée le signal de sortie J3 d'un autre diviseur par deux , DIV32 dont l'entrée est reliée à la sortie de INV32. Le signal de sortie de NOEX31 est le signal K3.

On va maintenant expliquer en référence à la figure 7 le fonctionnement du circuit de la figure 6 tel qu'il a été décrit ci-dessus.

Pour une meilleure compréhension de l'explication qui va suivre, on va se limiter dans l'intervalle de temps 2TR délimité par les lignes verticales L1 et L2. 2TR a une durée égale à deux périodes du signal A3. Au niveau du signal A3, dans l'intervalle 2TR , on désignera le premier front montant FR0, le premier front descendant FR1, le deuxième front montant FR2, le deuxième front descendant FR3 et le dernier front montant FR4.

Le signal A3 a une période PR dont l'alternance positive et l'alternance négative ont une durée égale à TR.

Le signal A3 est appliqué à l'entrée RAZ du TEMPO31 constituant les premiers moyens aptes à retarder d'un temps t31 le premier front FR1. En effet, TEMPO31 donne en sortie un signal B3 dans lequel le front FR1, ainsi que FR3 initialement descendants sont inversés et retardés de t31, et le front FR2 est seulement inversé.

Le signal B3 décrit ci-dessus appliqué à l'entrée du TEMPO32 constituant les deuxièmes moyens aptes à retarder le deuxième front FR2 d'un temps t32. En effet, TEMPO32 délivre le signal C3 comportant le front FR2 de nouveau inversé et retardé de t32, durée qui est deux fois plus grand que t31.

Dans l'intervalle 2TR, les retards t31 et t32 apparaissent chacun deux fois respectivement dans les signaux B3 et C3. Cependant, dans la suite, les retards t31 et t32 ne sont utilisés qu'une seule fois dans l'intervalle 2TR. Les retards non utilisés sont éliminés de la manière suivante :

Pour supprimer le premier retard t32, la porte NOR31 combine le signal D3 qui est le signal C3 inversé et le signal E3 qui est le signal B3 dont la période a été multipliée par deux, par DIV31. Ainsi, dans l'intervalle 2TR, le signal F3 à la sortie de NOR31 ne comporte qu'une seule alternance positive dont le front montant n'est autre que FR2 retardé de t32 et le front descendant est FR3, retardé de t31.

Ensuite, les signaux F3 et B3 sont appliqués aux entrées de la porte NOR32 qui délivre un signal H3 dont le front descendant correspond au front FR1 retardé de t31 se trouvant initialement dans le signal B3 et dont le deuxième front descendant correspond au front FR2 retardé de t32 se trouvant initialement dans le signal F3. Dans le signal H3, les fronts FR1, FR2 sont inversés par rapport aux signaux d'entrée B3 et F3, et le deuxième retard t31 présent dans le signal B3 est donc supprimé entraînant ainsi la suppression du front FR3. Ainsi, INV31, DIV32, NOR31, NOR32 constituent entre autres les moyens aptes à supprimer le deuxième front descendant FR3 puisque le front descendant de F3 coïncide avec un front montant de B3.

Par contre, dans le signal H3, il s'est créé un nouveau front montant s'insérant entre FR1 et FR2. Pour le supprimer, on combine H3 et G3, l'inverse de E3, ayant une période deux fois plus grande que B3. On obtient le signal I3 dans lequel ledit nouveau front montant est supprimé et les fronts FR1 et FR2 ont retrouvé leur sens initial comme dans le signal A3, c'est à dire FR1 front descendant et FR2 front montant. Ceci dit, dans l'intervalle 2TR, les fronts FR0 et FR4 marquant le début et la fin de 2TR sont supprimés.

Pour récupérer le front FR0 et inverser le front FR4 tout en gardant les fronts FR1 et FR2 dans l'état où ils se trouvent dans le signal I3, on combine par la porte NOEX31 le signal J3, sortie du DIV32, ayant une période quatre fois plus grande que le signal A3, et le signal I3, sortie de OEX31, pour délivrer le signal résultat K3. Si J3 est au niveau logique zéro, K3 est en opposition de phase avec I3 et si J3 est au niveau logique "1" ce qui est le cas sur tout l'intervalle 2TR, K3 est en phase avec I3 ce qui permet de récupérer les fronts FR1 et FR2 dans l'état souhaité décrit plus haut. Par ailleurs, J3 impose à I3, son front montant à la limite L1 et son front descendant à la limite L2. Ainsi, on retrouve le front montant FR0 initial mais le front FR4 montant se trouvant initialement à la frontière L2 est inversé dans le signal K3. Autrement dit, le signal K3 est inversé dans l'intervalle de temps délimité par L2 et L3, par rapport à l'intervalle 2TR. Ainsi, NOEX31, OEX31, DIV32 constituent les moyens aptes à inverser le troisième front montant FR4.

Dans l'intervalle de temps limité par L1 et L3, le signal K3 qui est également le signal de sortie du module de conversion 12b, a 3 périodes tandis que le signal d'entrée A3 a 4 périodes. Par conséquent, la conversion de fréquence dans un rapport 3 sur 4 a été réalisée. D'autre part, le signal K3 est parfaitement symétrique.

Dans ce troisième mode de réalisation préféré de l'invention, le retard t31 a été choisi sensiblement égal à un sixième d'une période du signal A3 et t32 est deux foix plus grand que t31. Cependant, les valeurs de ces retards peuvent être choisis différemment par l'Homme du métier.

Autrement dit, le principe mis en oeuvre dans ce troisième mode de réalisation consiste, sur un intervalle de temps 2TR égal à deux périodes PR du signal d'entrée A3 commençant à un front montant FR0, à :

- retarder le premier front descendant FR1 d'un temps t31 sensiblement égal un sixième de la durée d'une période du signal d'entrée
- retarder le deuxième front montant FR2 d'un temps t32 qui est le double de t31
- supprimer le deuxième front descendant FR3
- inverser le troisième front montant FR4

Dans l'intervalle de temps suivant L2,L3 correspondant également à une durée égale à 2TR, la combinaison des signaux I3, et J3 permet d'obtenir un signal K3 dont les fronts sont inversés par rapport aux fronts du signal K3 dans l'intervalle de temps précédent L1,L2. Ainsi le signal K3 présente des alternances positives et négatives d'égale durée.

De manière usuelle un alternateur de véhicule automobile comprend un régulateur contenu dans un boîtier, ledit boîtier comportant au moins une entrée phase, une sortie pour la régulation et une sortie destinée à la commande du compte-tours.

De manière avantageuse le moyen de conversion décrit ci-dessus est inséré dans le boîtier du régulateur.

## Revendications

1. Dispositif de mesure de la vitesse de rotation d'un moteur thermique, notamment pour véhicules automobile, comprenant:

   un appareil de mesure (13) apte à recevoir un signal de manière à indiquer une valeur correspondant à la vitesse de rotation dudit moteur, une machine électrique tournante (11), couplée mécaniquement au moteur thermique et apte à délivrer au moins un signal représentatif de la vitesse de rotation dudit moteur thermique, ledit signal présentant une caractéristique dépendant de la nature de machine électrique tournante (11), un moyen de conversion (12) disposé entre ladite machine tournante (11) et ledit appareil de mesure (13), apte à délivrer audit appareil de mesure un signal (D11; M2; K3) ayant un premier nombre d'impulsions par tour, à partir d'un ou plusieurs signaux (A11, A12, A13; A2; A3) ayant un deuxième nombre d'impulsions par tour délivré par ladite machine tournante (11), le deuxième nombre étant différent du premier nombre, ledit appareil de mesure (13) consistant en un compte-tours destiné à recevoir dudit moyen de conversion (12) un signal ayant undit premier nombre d'impulsions par tour, et ladite machine tournante (11) consistant en un alternateur délivrant des signaux phase (A11, A12, A13; A2; A3) ayant undit deuxième nombre d'impulsions par tour, caractérisé en ce que ledit premier nombre d'impulsions par tour (n6) est proportionnel à six et ledit deuxième nombre d'impulsions par tour (n8) est proportionnel à huit.

2. Dispositif de mesure selon la revendication 1, caractérisé en ce que ledit moyen de conversion (12) est apte à délivrer audit compte-tours (13) un signal ayant undit premier nombre d'impulsions par tour, à partir de trois signaux phase (A11, A12, A13) ayant undit deuxième nombre d'impulsions par tour délivrés par l'alternateur (11).

3. Dispositif de mesure selon la revendication 2, caractérisé en ce qu'il comporte des moyens logiques (NOR11, NOR12, NOR13, NOR14) aptes à combiner les trois signaux phase (A11, A12, A13) de manière à délivrer un signal (C11) présentant un nombre d'impulsions par tour trois fois plus grand que l'un des signaux phase (A11, A12, A13).

4. Dispositif de mesure selon la revendication 3, caractérisé en ce qu'il comporte des moyens diviseurs (DIV11) sur lesquels est appliqué le signal (C11), aptes à délivrer un signal (D11) présentant undit premier nombre d'impulsions par tour (n6).

5. Dispositif de mesure selon la revendication 1, caractérisé en ce que le moyen de conversion (12) comporte des moyens aptes à délivrer au compte-tours (13) un signal (M2; K3) ayant undit premier nombre d'impulsions par tour, à partir d'un seul signal phase ayant undit deuxième nombre d'impulsions par tour délivré par l'alternateur (11).

6. Dispositif de mesure selon la revendication 5, caractérisé en ce que le signal phase (A2) étant un signal rectangulaire périodique de période PR constitué d'alternances négatives et positives de durée TR, le moyen de conversion (12) comporte des moyens (DIV21, DIV22, OEX21) aptes à déterminer un intervalle de deux périodes et à provoquer toutes les deux périodes une inversion dudit dudit signal phase (A2) de manière à obtenir un signal (D2) présentant undit premier nombre d'impulsions par tour (n6) et constitué d'alternances négatives (AN1, AN2, AN3) et d'alternances positives (AP1, AP2, AP3) de durées égales à TR ou à deux fois TR.

7. Dispositif de mesure selon la revendication 6, caractérisé en ce que le moyen de conversion (12) comporte des moyens (AND21, TEMPO21) aptes à prolonger d'une durée déterminée (t21) une alternance positive (AP3) de durée TR qui suit une alternance négative de durée TR.

8. Dispositif de mesure selon la revendication 6, caractérisé en ce que le moyen de conversion (12) comporte des moyens (INV22, AND22, TEMPO22) aptes à prolonger d'une durée déterminée (t22) une alternance négative (AN1) de durée TR qui suit une alternance positive de durée TR.

9. Dispositif de mesure selon la revendication 5, caractérisé en ce que le signal phase (A3) étant un signal rectangulaire périodique de période PR, constitué notamment d'un front montant et d'un front descendant, le moyen de conversion (12) comporte sur une durée (2TR) égale à deux périodes PR commençant à un front montant (FR0), des premiers moyens (TEMPO31) aptes à retarder le premier front descendant (FR1) d'un temps t31, des seconds moyens (TEMPO32) aptes à retarder le deuxième front montant (FR2) d'un temps t32, des troisièmes moyens (DIV31, INV31, NOR31, NOR32) aptes à supprimer le deuxième front descendant (FR3) et des quatrièmes moyens (OEX31, DIV32, NOEX31) aptes à inverser le troisième front montant (FR4) de manière à générer un signal (K3) comportant un premier nombre d'impulsions par tour (n6).

10. Dispositif de mesure selon la revendication 9, caractérisé en ce que le temps t31 est égal à un tiers d'une demi-période PR du signal phase (A3).

11. Dispositif de mesure selon la revendication 10, caractérisé en ce que le temps t32 est deux fois plus grand que t31.

12. Dispositif de mesure selon l'une quelconque des revendications précédentes, caractérisé en ce que la machine tournante électrique (11) comprend un boîtier de régulateur recevant au moins un signal (A11,A12,A13 ; A2 ; A3) ayant undit deuxième nombre d'impulsions par tour et comportant une borne de sortie destinée à la commande de l'appareil de mesure (13), le moyen de conversion (12) est intégré dans ledit boîtier.

**Patentansprüche**

1. Vorrichtung zur zur Messung der Drehgeschwindigkeit eines Verbrennungsmotors, insbesondere für Kraftfahrzeuge, umfassend:

   - ein Meßgerät (13), das ein Signal empfangen kann, um einen der Drehgeschwindigkeit des besagten Motors entsprechenden Wert anzugeben,

- eine rotierende elektrische Maschine (11), die mechanisch an den Verbrennungsmotor gekoppelt und in der Lage ist, mindestens ein für die Drehgeschwindigkeit des besagten Verbrennungsmotors repräsentatives Signal zu liefern, wobei das besagte Signal eine Kennlinie aufweist, die von der Art der rotierenden elektrischen Maschine (11) abhängig ist, wobei zwischen der besagten rotierenden Maschine (11) und dem besagten Meßgerät (13) ein Umwandlungsmittel (12) angeordnet ist, das dem besagten Meßgerät ein Signal (D11; M2; K3) liefern kann, das eine erste Impulszahl pro Umdrehung hat, ausgehend von einem oder mehreren durch die besagte rotierende Maschine (11) gelieferten Signalen (A11, A12, A13; A2; A3), die eine zweite Impulszahl pro Umdrehung haben, wobei die zweite Zahl von der ersten Zahl verschieden ist, wobei das besagte Meßgerät (13) aus einem Drehzahlmesser besteht, der dazu bestimmt ist, von dem besagten Umwandlungsmittel (12) ein Signal zu empfangen, das eine besagte erste Impulszahl pro Umdrehung hat, und wobei die besagte rotierende Maschine (11) aus einem Wechselstromgenerator besteht, der Phasensignale (A11, A12, A13; A2; A3) liefert, die eine besagte zweite Impulszahl pro Umdrehung haben, **dadurch gekennzeichnet**, daß die besagte erste Impulszahl pro Umdrehung (n6) proportional zu sechs und die besagte zweite Impulszahl pro Umdrehung (n8) proportional zu acht ist.

2. Meßvorrichtung nach Anspruch 1 , **dadurch gekennzeichnet**, daß das besagte Umwandlungsmittel (12) in der Lage ist, dem besagten Drehzahlmesser (13) ein Signal zu liefern, das eine erste Impulszahl pro Umdrehung hat, ausgehend von drei durch den Wechselstromgenerator (11) gelieferten Phasensignalen (A11, A12, A13), die eine zweite Impulszahl pro Umdrehung haben.

3. Meßvorrichtung nach Anspruch 2 , **dadurch gekennzeichnet**, daß sie logische Mittel (NOR11, NOR12, NOR13, NOR14) umfaßt, die in der Lage sind, die drei Phasensignale (A11, A12, A13) zu kombinieren, um ein Signal (C11) zu liefern, das eine Impulszahl pro Umdrehung aufweist, die dreimal so groß wie eines der Phasensignale (A11, A12, A13) ist.

4. Meßvorrichtung nach Anspruch 3 , **dadurch gekennzeichnet**, daß sie Divisionsmittel (DIV11) umfaßt, an die das Signal (C11) angelegt wird und die in der Lage sind, ein Signal (D11) zu liefern, das eine erste besagte Impulszahl pro Umdrehung (n6) aufweist.

5. Meßvorrichtung nach Anspruch 1 , **dadurch gekennzeichnet**, daß das Umwandlungsmittel (12) Mittel umfaßt, die in der Lage sind, dem Drehzahlmesser (13) ein Signal (M2; K3) zu liefern, das eine besagte erste Impulszahl pro Umdrehung hat, ausgehend von einem einzigen durch den Wechselstromgenerator (11) gelieferten Phasensignal, das eine besagte zweite Impulszahl pro Umdrehung hat.

6. Meßvorrichtung nach Anspruch 5 , **dadurch gekennzeichnet**, daß, während das besagte Phasensignal (A2) ein periodisches Rechtecksignal mit der Periode PR ist, das aus positiven und negativen Halbperioden mit der Dauer TR besteht, das besagte Umwandlungsmittel (12) Mittel (DIV21, DIV22, OEX21) umfaßt, die in der Lage sind, ein Intervall von zwei Perioden zu bestimmen und alle zwei Perioden eine Umkehrung des besagten Phasensignals (A2) zu bewirken, um ein Signal (D2) zu erhalten, das eine erste Impulszahl pro Umdrehung (n6) aufweist und aus negativen Halbperioden (AN1, AN2, AN3) und positiven Halbperioden (AP1, AP2, AP3) mit einer Dauer gleich TR oder dem Zweifachen von TR besteht.

7. Meßvorrichtung nach Anspruch 6 , **dadurch gekennzeichnet**, daß das Umwandlungsmittel (12) Mittel (AND21, TEMP021) umfaßt, die in der Lage sind, eine positive Halbperiode (AP3) mit der Dauer TR, die auf eine negative Halbperiode mit der Dauer TR folgt, um eine bestimmte Dauer (t21) zu verlängern.

8. Meßvorrichtung nach Anspruch 6 , **dadurch gekennzeichnet**, daß das Umwandlungsmittel (12) Mittel (INV22, AND22, TEMPO22) umfaßt, die in der Lage sind, eine negative Halbperiode (AN1) mit der Dauer TR, die auf eine positive Halbperiode mit der Dauer TR folgt, um eine bestimmte Dauer (t22) zu verlängern.

9. Meßvorrichtung nach Anspruch 5 , **dadurch gekennzeichnet**, daß, während das Phasensignal (A3) ein periodisches Rechtecksignal mit der Periode PR ist, das insbesondere aus einer ansteigenden Flanke und einer abfallenden Flanke besteht, das Umwandlungsmittel (12) über eine Dauer (2TR) gleich zwei Perioden PR, beginnend bei einer ansteigenden Flanke (FR0), erste Mittel (TEMPO31), die in der Lage sind, die erste abfallende Flanke (FR1) um eine Zeit t31 zu verzögern, zweite Mittel (TEMPO32), die in der Lage sind, die zweite ansteigende Flanke (FR2) um eine Zeit t32 zu verzögern, dritte Mittel (DIV31, INV31, NOR31, NOR32), die in der Lage sind, die zweite abfallende Flanke (FR3) zu unterdrücken, und vierte Mittel (OEX31, DIV32, NO-EX31) umfaßt, die in der Lage sind, die dritte ansteigende Flanke (FR4) umzukehren, um ein Signal (D3) zu erzeugen, das eine erste Impulszahl pro Umdrehung (n6) umfaßt.

10. Meßvorrichtung nach Anspruch 9 , **dadurch gekennzeichnet**, daß die Zeit t31 gleich einem Drittel einer halben Periode PR des Phasensignals ist.

11. Meßvorrichtung nach Anspruch 10 , **dadurch gekennzeichnet**, daß die Zeit t32 zweimal so groß wie t31 ist.

12. Meßvorrichtung nach einem der vorangehenden Ansprüche , **dadurch gekennzeichnet**, daß die rotierende elektrische Maschine (11) ein Reglergehäuse umfaßt, das mindestens ein Signal (A11, A12, A13; A2; A3) empfängt, das eine besagte zweite Impulszahl pro Umdrehung hat, und das eine Ausgangsklemme enthält, die zur Steuerung des Meßgeräts (13) bestimmt ist, wobei das Umwandlungsmittel (12) in das besagte Gehäuse integriert ist.

**Claims**

1. Apparatus for measuring the speed of rotation of a heat engine, especially for motor vehicles, comprising:

   - a measuring device (13) adapted to receive a signal such as to indicate a value corresponding to the speed of rotation of the said engine,

   - a rotary electrical machine (11), coupled mechanically to the heat engine and adapted to deliver at least one signal representing the speed of rotation of the said heat engine, the said signal having a characteristic dependent on the nature of the rotary electrical machine (11), a conversion means (12) disposed between the said rotary machine (11) and the said measuring device (13), and adapted to deliver to the said measuring device a signal (D11; M2; K3;) having a first number of pulses per revolution, derived from one or more signals (A11, A12, A13; A2; A3) having a second number of pulses per revolution and delivered by the said rotary machine (11), the second number being different from the first number, the said measuring device (13) consisting of a revolution counter adapted to receive, from the said conversion means (12), a signal having a said first number of pulses per revolution, and the said rotary machine (11) consisting of an alternator delivering phase signals (A11, A12, A13; A2; A3) having a said second number of pulses per revolution, characterised in that the said first number of pulses per revolution (n6) is proportional to six and the said second number of pulses per revolution (n8) is proportional to eight.

2. Measuring apparatus according to Claim 1, characterised in that the said conversion means (12) is adapted to deliver to the said revolution counter (13) a signal having a said first number of pulses per revolution, derived from three phase signals (A11, A12, A13) having a said second number of pulses per revolution and delivered by the alternator (11).

3. Measuring apparatus according to Claim 2, characterised in that it includes logic means (NOR11, NOR12, NOR13, NOR14), which are adapted to combine the three phase signals (A11, A12, A13) in such a way as to deliver a signal (C11) having a number of pulses per revolution three times as great as one of the phase signals (A11, A12, A13).

4. Measuring apparatus according to Claim 3, characterised in that it includes dividing means (DIV11) to which the signal (C11) is applied, and which are adapted to deliver a signal (D11) having a said first number of pulses per revolution (n6).

5. Measuring apparatus according to Claim 1, characterised in that the conversion means (12) comprises means adapted to deliver to the revolution counter (13) a signal (M2; K3;) having a said first number of pulses per revolution, derived from a single phase signal having a said second number of pulses per revolution delivered by the alternator (11).

6. Measuring apparatus according to Claim 5, characterised in that, the phase signal (A2) being a periodic rectangular signal of period PR consisting of negative and positive alternations of duration TR, the conversion means (12) includes means (DIV21, DIV22, OEX21) adapted to determine a time interval of two periods and to cause, in both periods, an inversion of the said phase signal (A2) in such a way as to obtain a signal (D2) having a said first number of pulses per revolution (n6) and consisting of negative alternations (AN1, AN2, AN3) and positive alternations (AP1, AP2, AP3) of durations equal to TR or to twice TR.

7. Measuring apparatus according to Claim 6, characterised in that the conversion means (12) comprises means (AND21, TEMPO21) adapted to extend, for a predetermined duration (t21) a positive alternation (AP3) of duration TR which follows a negative alternation of duration TR.

8. Measuring apparatus according to Claim 6, characterised in that the conversion means (12) comprises means (INV22, AND22, TEMPO22) adapted to prolong by a predetermined time (t22) a negative alternation (AN1) of duration TR which follows a positive alternation of duration TR.

9.  Measuring apparatus according to Claim 5, characterised in that, the phase signal (A3) being a periodic rectangular signal of period PR, consisting in particular of a rising front and a descending front, the conversion means (12) includes, for a duration (2TR) equal to two periods PR beginning with a rising front (FRO), first means (TEMPO31) adapted to retard the first descending front (FR1) by a time t31, second means (TEMPO32) adapted to retard the second rising front (FR2) by a time t32, third means (DIV31, INV31, NOR31, NOR32) adapted to suppress the second descending front (FR3), and fourth means (OEX31, DIV32, NOEX31) adapted to invert the third rising front (FR4) in such a way as to generate a signal (K3) comprising a first number of pulses per revolution (n6).

10. Measuring apparatus according to Claim 9, characterised in that the time t31 is equal to one third of a half period PR of the phase signal (A3).

11. Measuring apparatus according to Claim 10, characterised in that the time t32 is twice as great as t31.

12. Measuring apparatus according to any one of the preceding Claims, characterised in that the rotary electrical machine (11) includes a regulating unit receiving at least one signal (A11, A12, A13; A2; A3) having a said second number of pulses per revolution and including an output terminal arranged for control of the measuring device (13), the conversion means (12) being incorporated in the said unit.

FIG.1

EP 0 660 116 B1

**FIG.2**

**FIG.3**

FIG. 4

FIG.6

FIG.5

FIG.7